# EUROPEAN PATENT SPECIFICATION

(11) **EP 2 161 745 B1**
(45) Date of publication and mention of the grant of the patent: **08.08.2012**
(21) Application number: 08015769.6
(22) Date of filing: 08.09.2008
(51) Int. Cl.: H01L 23/473, H01L 25/07, H01L 25/11, H01L 23/367

(54) **Stack assemblies containing semiconductor devices**
Stapelanordnungen, die Halbleitervorrichtungen enthalten
Ensembles d'empilement contenant des dispositifs à semi-conducteur

(43) Date of publication of application: 10.03.2010
(73) Proprietor: Converteam Technology Ltd, Rugby Warwickshire CV21 1BU (GB)
(72) Inventor: Crane, Allan David, Clifton upon Dunsmore Rugby Warickshire CV23 0BH (GB); Bradley, Stuart Ian, Clarendon Park Leicester LE2 1YD (GB); Loddick, Sean Joseph, Rugby Warwickshire CV21 4BG (GB)
(74) Representative: Thacker, Darran Ainsley

(56) References cited:
- DE-A1- 2 739 520
- JP-A- 8 097 338
- JP-A- 2005 019 849
- RU-C1- 2 151 448
- US-A- 4 010 489
- US-A- 4 301 465
- US-A- 6 002 183

## Description

### Technical Field

The present invention relates to stack assemblies containing semiconductor devices, and in particular to stack assemblies that are specifically designed to be immersed in a liquid dielectric.

### Background Art

DE 2739520 describes a stack assembly where semiconductor devices 1 are interspersed between coolers 2 that operate functionally as heatsinks. The semiconductor devices 1 and coolers 2 are held together as a stack assembly by bolts 6, 7 which apply a contact compression force. The coolers 2 have radial ribs 17 that define axial or helical channels through which oil can flow. The coolers 2 also provide electrical power to the semiconductor devices 1 as shown schematically in Figure 3 of DE 2739520. The stack assembly is immersed in an oil-filled tank and surrounded by an insulating jacket 23. The individual semiconductor devices 1 are of a conventional press pack construction and are hermetically sealed inside a housing.

Similar arrangements are also disclosed in RU 2151448, JP 08-097338 and US 4010489.

JP 2005-019849 discloses an apparatus where a substrate-mounted semiconductor chip structure is directly immersed in an insulating fluid for cooling purposes.

### Summary of the Invention

The present invention is defined by claim 1. Preferred embodiments are defined in the dependent claims.

The stack assembly preferably comprises a plurality of semiconductor devices with each semiconductor device being located between a pair of heatsinks.

The stack assembly can be formed using a wide variety of different semiconductor devices, although whole wafer devices (e.g. thyristors, gate turn-off thyristors (GTOs), gate commutated thyristors or gate controlled thyristors (GCTs) and diodes) are preferred. A single stack assembly may contain any desired combination of semiconductor devices, subject to them all being suitable for the same contact compression force that is used to hold the semiconductor devices and heatsinks in compression and is described in more detail below.

A typical semiconductor device will include a semiconductor wafer or body, ohmic contact metallisation, a pressure contact system, passivation layers (e.g. glassy, polyamide, polyimide, silicone rubber or the other suitable material in single or multilayer configurations) and thermally compensated mechanical contact plates.

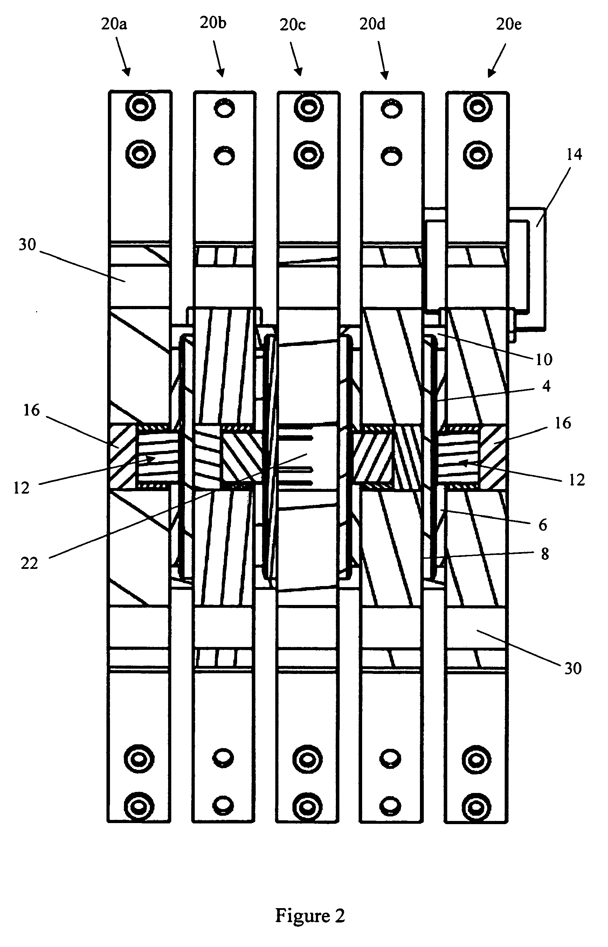

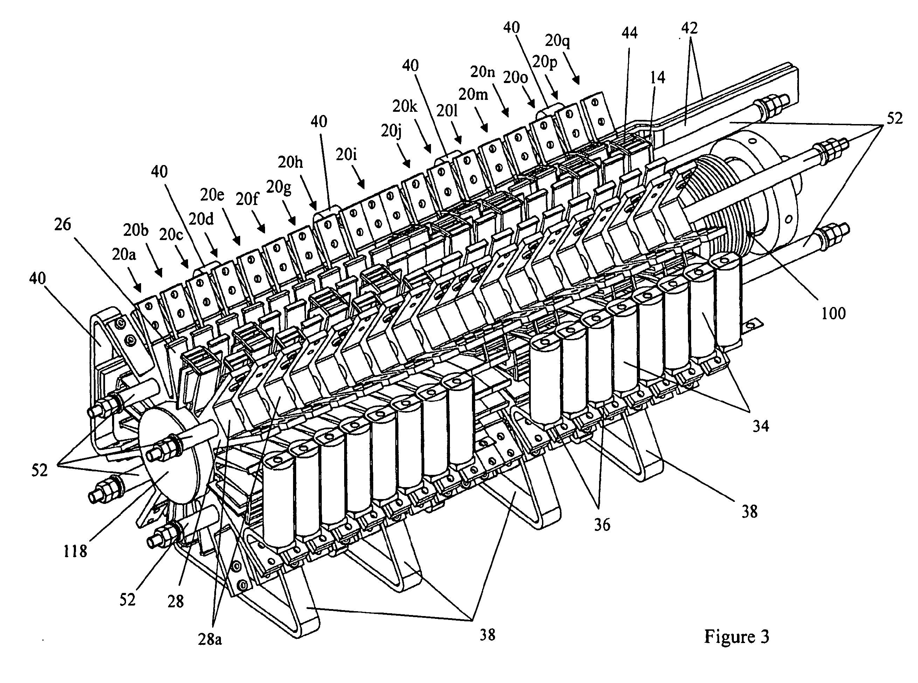

In a conventional press pack construction, the semiconductor body and contacts plates are pressed between a pair of copper pole pieces. An example of a conventional press pack construction is shown in United States Patent 6441407. More particularly, Figures 2c and 3a of United States Patent 6441407 show a perspective view of a GTO 33 in which a semiconductor body 31 is arranged between contact plates 32 and hermetically sealed in an insulating housing 30. The semiconductor body 31 and the contact plates 32 are pressed between copper pole pieces 33 and 34.

The or each semiconductor device has an "open" construction. A stack assembly includes at least one semiconductor device having an "open" construction and can include a semiconductor device having a press pack construction. A combination of different semiconductor device constructions is therefore possible within the same stack assembly.

It is believed that semiconductors devices having an "open" construction will benefit most from being immersed in the liquid dielectric. This is because any spaces or gaps between the various component parts of the semiconductor device will be flooded with the liquid dielectric to provide a suitable dielectric environment. The materials used in the semiconductor device must be chemically, structurally and dielectrically compatible with the liquid dielectric so that neither the semiconductor device nor the liquid dielectric are degraded as a result of their contact. It will be readily appreciated that such a semiconductor device is differentiated from a conventional press pack construction because it is not hermetically sealed in a housing which allows all regions of the semiconductor body to be surrounded and permeated by a suitable moderately pressurised dielectric gas, e.g. dry nitrogen. The semiconductor device also lacks the copper pole pieces that are associated with conventional press pack semiconductor devices. The copper pole pieces are effectively replaced by the heatsinks. The conventional enclosure parts would normally account for about half of the total cost of the conventional press pack semiconductor device. The lack of conventional enclosure parts in a semiconductor device having an "open" construction therefore provides significant cost benefits.

The periphery of the semiconductor device having an "open" construction may be encapsulated or otherwise sealed to limit the ingress of pollutants whilst in storage or when assembled within the stack assembly. Moreover, encapsulation (e.g. using a rubber or other compliant outer ring) may also be used to protect the semiconductor device against impact or shock during mechanical handling. It is important to note that the use of such encapsulation around the periphery of the semiconductor device does not detract from the advantages of the "open" construction described above.

A contact compression force (clamping force) is preferably applied substantially along the axis of the stack assembly to ensure proper thermal and electrical contact between the or each semiconductor device and adjacent heatsinks. The contact compression force also ensures proper thermal and electrical contact between the electrical plates of the semiconductor device and the semiconductor wafer or body. The contact areas of the two faces of the semiconductor body are suitably metallised to facilitate reliable thermal and electrical contacts, taking into consideration that the respective contact areas are different and will therefore experience different contact pressures. In the case of GTOs that employ a plurality of individual raised emitter mesas, i.e. arrays of raised cathode contact islands whose total contact area is considerably less than that of the corresponding anode contact area, the respective contact pressures will be substantially different and the contact compression force must be selected accordingly.

The stack assembly is preferably held in compression by a common pressure contact system (clamping system). The contact compression force will be precisely determined and substantially constantly applied by the pressure contact system substantially along the axis of the stack assembly. The pressure contact system is such that the asperities or slight projections on adjoining metallic surfaces experience plastic deformation, thereby increasing the inter-metallic contact area as required to reduce thermal contact resistance and electrical contact resistance. In practice, the contact compression force applied by the pressure contact system will be about 50% of that which would cause the semiconductor wafer or body to fracture. Further increases in the contact compression force are normally unproductive in terms of reducing contact resistances. After first compression and associated plastic flow, the contact compression force may be reduced to a limited degree without unreasonable contact resistance degradation, i.e. the process is subject to hysteresis. As such, the pressure contact system must be precisely toleranced.

Any convenient common pressure contact system may be used.

The stack assembly may include a rigid structure that can be resiliently mounted to a suitable support to locate the stack assembly in use while substantially isolating the or each semiconductor device from shocks. The heatsinks may be adapted as necessary to allow external forces to be applied to the stack assembly to locate and align it. Radial alignment may be provided by the rigid structure through sliding interfaces. For example, the rigid structure may include one or more rigid longitudinal members that are in sliding contact with a contact surface of the heatsinks.

Support rods for carrying predominantly tensile loads may be passed through angularly spaced openings in the heatsinks. The ends of the support rods are preferably secured to the rigid structure of the stack assembly.

Semiconductor devices may be configured in any convenient power circuit topology e.g. current source inverter, voltage source inverter, matrix converter and rectifier. Power circuit topologies can be integrated with associated passive components. A complete power circuit topology can be configured within a single stack assembly or may be distributed within any convenient number of stack assemblies. Semiconductor devices within the same stack assembly or different stack assemblies may be connected in series or parallel. Power circuit topologies may be configured using any convenient number of stack assemblies and each stack assembly may contain a convenient number of semiconductor devices or be of any convenient physical size. A combination of semiconductors having "open" and fully housed press pack constructions may be used.

Cables or busbars can be used to connect semiconductor devices within a particular stack assembly in order to achieve a desired power circuit topology. For example, a six pulse Greatz bridge diode rectifier would use a first busbar to link the anodes of three diode devices together to provide a negative dc terminal and a second busbar to link the cathodes of three other diode devices together to provide a positive dc terminal. Cables or busbars may also be used to connect a semiconductor device in one stack assembly to a semiconductor device in a different stack assembly.

A single stack assembly or a plurality of stack assemblies may form the basic components of either a stand-alone power converter or a power converter that is physically integrated with other equipment (e.g. an electrical machine with integrated power electronics).

Immersing the stack assembly in the liquid dielectric permits highly effective and compact thermal interfaces to be employed without the risk of insulation breakdown that is normally associated with conventional air-insulated semiconductor devices. The stack assembly construction therefore enables the current, voltage and power ratings that may be achieved within a given space to be maximised. The stack assembly construction also enables power conversion apparatus to have extremely high power density and low cost, particularly when components and systems are extensively integrated. The liquid dielectric provides cooling and a dielectric environment in which the stack assembly can be safely operated.

The use of the liquid dielectric is beneficial to the electrical insulation and cooling of switching aid network components, gate drive components and other associated passive components that may also be immersed in close proximity to the stack assembly and connected thereto.

Any suitable liquid dielectric may be employed. It will be readily appreciated that the term "liquid dielectric" is not just intended to cover proprietary liquids that are specifically marketed as such, but any liquid that has a sufficient dielectric withstand. This would include de-ionised water, FLUORINERT and other equivalent perfluorocarbon fluids, mineral transformer oils, silicone transformer oils, synthetic oils and esters, methylene chloride etc. A particularly preferred coolant fluid is a proprietary transformer insulating fluid such as MIDEL and its equivalents. Any coolant fluid will be subject to various environmental and chemical compatibility considerations.

The heatsinks may have a plurality of radial cooling fins for dissipating heat produced during operation of the stack assembly into the surrounding liquid dielectric. The heatsinks may be manufactured from any suitable material such as aluminium, copper and their alloys, and by any suitable process such as extrusion, sintering, sinter-forging, casting, machining etc. Moreover, the surfaces of the heatsinks may be textured by any convenient process so as to enhance their surface area or to beneficially influence the boundary layer flow with the liquid dielectric and heat exchange behaviour. The heatsinks provide the compressive compliance, thermal and electrical connections of the copper pole pieces found in a conventional press pack semiconductor device but additionally provide a short thermal conducting path between the or each semiconductor device and a large wetted metallic heat exchange area. Heat generated during the operation of the semiconductor devices can therefore be efficiently transferred into the liquid dielectric surrounding the stack assembly.

Although the liquid dielectric surrounding the stack assembly can be stationary, it is generally preferred that the liquid dielectric flows past the stack assembly to provide improved cooling. If the heatsinks include radial fins then the liquid dielectric will preferably flow in a direction that is substantially parallel to the axis of the stack assembly so that the liquid dielectric flows around and between the radial fins. However, in practice the liquid dielectric may flow in any direction relative to the axis of the stack assembly.

The flow of liquid dielectric past the stack assembly may be provided by a suitable pump system or by natural convection (thermosyphon), for example. Baffles or ducts may be provided to direct the flow of the liquid dielectric for optimum cooling of the stack assembly.

The liquid dielectric must be substantially de-aerated and de-gassed. A self-bleeding fluid circuit with an air and gas bubble separator can be employed.

In a preferred embodiment the stack assembly as described above is located in a chamber or reservoir containing a liquid dielectric such that the stack assembly is at least partially (and preferably completely) immersed in the liquid dielectric. The stack assembly can be immersed in a suitable pre-existing or purpose-made chamber or reservoir within the fluid cooling circuit of an electrical machine, for example.

Alternatively, the stack assembly can be located in a fluid-tight housing to which liquid dielectric is supplied and removed through pipes or manifolds. A plurality of such housings containing one or more stack assemblies may be provided at angularly spaced-apart locations around the stator assembly of an air cooled electrical machine. The or each housing may be supplied with ac or dc power through cables or busbars for the operation of the or each semiconductor device. The or each fluid-tight housing may be made of any convenient material. If the housing is made of a metallic material then it is preferably earthed using suitable insulation bushes or the like. A removable lid may provide access to the interior of the housing for maintenance and repair of the stack assemblies.

One or more of the radial fins may be adapted to allow auxiliary electrical components (e.g. gate drive electronics and switching aid networks) to be mounted on the heatsinks and to allow electrical connections to be made between heatsinks or to external components by means of suitable cables or busbars, for example.

### Drawings

Figure 1 is an exploded perspective view of a basic stack assembly of the present invention with four semiconductor devices of "open" construction interspersed between five heatsinks;
Figure 2 is a cross section view of the assembled stack assembly of Figure 2;
Figure 3 is a perspective view showing a detailed stack assembly of the present invention complete with a common pressure contact system, support rods, busbars and auxiliary electrical components etc.;
Figure 4 is a perspective view of the detailed stack assembly of Figure 3 showing the rigid support structure;
Figure 5 is a side view of the detailed stack assembly of Figure 3 showing the rigid support structure;
Figure 6A is a schematic representation of a four phase bridge;
Figure 6BA is a schematic representation of a twelve pulse series thyristor rectifier; and
Figures 7 to 9 are detail views of a common pressure contact system that can be used to apply a contact compression force to the stack assembly.

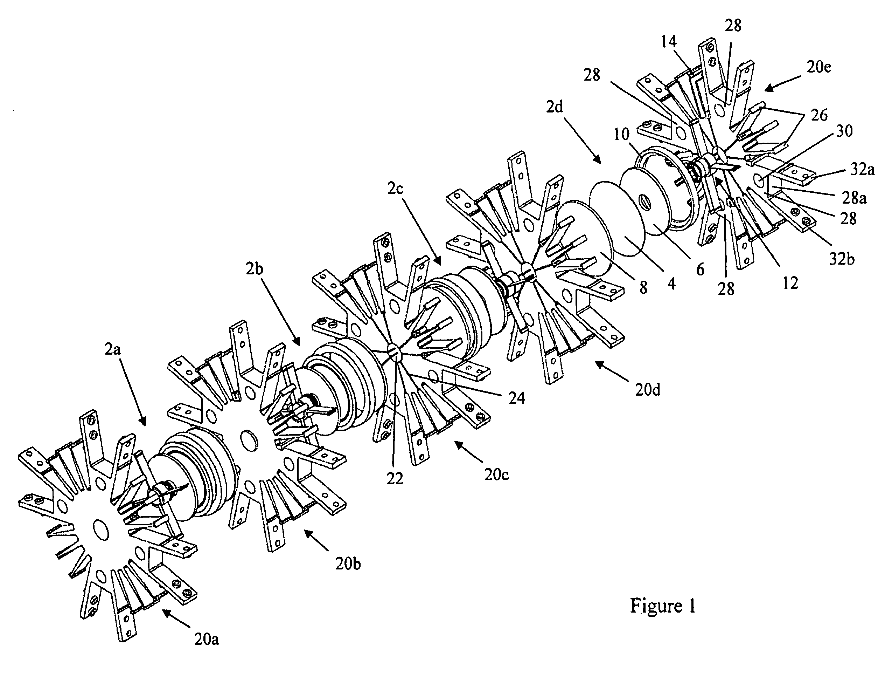

A basic stack assembly according to the present invention will now be described with reference to Figures 1 and 2.

The stack assembly includes four semiconductor devices 2a-2d having any suitable topology. For example, in the case where the semiconductor device 2d is a gate turn-off thyristor (GTO) then it may include a semiconductor body or wafer 4 where a cathode layer is defined by a plurality of individual raised mesas. The outer surfaces of the raised mesas are covered with a metal layer to form a plurality of individual cathode electrodes. The outer surface of a base layer is covered with a continuous metal layer to form a gate electrode that effectively surrounds the raised mesas of the cathode layer.

A cathode plate 6 in the form of a molybdenum disc contacts the individual cathode electrodes of the semiconductor body 4. An anode plate 8 also in the form of a molybdenum disc contacts the outer surface of an anode layer of the semiconductor body 4.

The semiconductor body 4 is encapsulated within a compliant outer ring 10 and the cathode and anode plates 6, 8. The outer ring 10 limits the ingress of pollutants into the semiconductor device whilst in storage or when assembled within the stack assembly and protects the semiconductor body 4 against impact or shock during mechanical handling.

A gate drive connection 12 is provided along which a gate current and an auxiliary cathode current can flow between the semiconductor device and an external gate drive circuit 14.

The semiconductor devices 2a-2d are interspersed between five heatsinks 20a-20e of identical construction. Each heatsink is equivalent to the copper pole piece in a conventional press pack construction. The gate drive connections 12 are located within an opening 22 provided in an adjacent heatsink. More particularly, the gate drive connection for the first semiconductor device 2a is received in the opening provided in the first heatsink 20a; the gate drive connection for the second semiconductor device 2b is received in the opening provided in the second heatsink 20b; the gate drive connection for the third semiconductor device 2c is received in the opening provided in the fourth heatsink 20d; and the gate drive connection for the fourth semiconductor device 2d is received in the opening provided in the fifth heatsink 20e. It will therefore be readily appreciated that the stack assembly is symmetrically arranged about the third heatsink 20c. There is no gate drive connection received in the opening provided in the third heatsink 20c and, in practice, the opening may be omitted completely.

The first heatsink 20a acts as the cathode side pole piece for the first semiconductor device 2a. The second heatsink 20b acts as the anode side pole piece for the first semiconductor device 2a and as the cathode side pole piece for the second semiconductor device 2b. The third heatsink 20c acts as the anode side pole piece for the second and third semiconductor devices 2b and 2c. The fourth heatsink 20d acts as the cathode side pole piece for the third semiconductor device 2c and as the anode side pole piece for the fourth semiconductor device 2d. The fifth heatsink 20e acts as the cathode side pole piece for the fourth semiconductor device 2d.

Narrow slots 24 may extend radially outwardly from the opening 22 of each heatsink 20a-20e to an outer surface. Radially extending conductor elements of the gate drive connections 12 are located within the slots 24 and project beyond the outer surface of the heatsink so that they can be connected to the gate drive circuit 14, only one of which is shown in Figures 1 and 2.

The openings 22 and slots 24 in the heatsinks 20a-20q are sized so that the gate drive connections 12 are spaced apart from the heatsinks to prevent any electrical contact between them. Although not shown, the gaps between the gate drive connections 12 and the heatsinks may be filled by a dielectric material.

A compressible insulating disc 16 is located in the opening 22 provided in the first, second, fourth and fifth heatsinks. One side of each insulating disc is in direct contact with the associated gate drive connection 12 while the opposite side is in direct contact with the anode plate of the adjacent semiconductor device or an insulation pad (not shown). The thickness of the insulating disc can be selected to provide a desired axial contact pressure for the gate drive connections 12. In other words, a thicker insulating disc 16 will result in a greater axial contact pressure being applied between the gate drive connection 12 and the semiconductor body 4 or *vice versa.*

The heatsinks 20a-20e are provided with a plurality of circumferentially spaced radial cooling fins 26 for dissipating the heat that is produced during the normal operation of the semiconductor devices 2a-2d into a surrounding liquid dielectric coolant. The heatsinks 20a-20q include four equally spaced fins 28 of increased thickness. Each of the fins 28 includes an opening 30 for receiving a support rod that is described in more detail below, and a pair of mounting arms 32a, 32b.

A common contact pressure system (not shown) applies a contact compression force along the axis of the stack assembly to maintain proper electrical and thermal contact is maintained between the cathode and anode plates 6, 8 of each semiconductor device 2a-2e and the contact surfaces of the adjacent heatsinks 20a-20e. The contact compression force also maintains proper electrical and thermal contact between the cathode and anode plates 6, 8 and the semiconductor body 4 of each semiconductor device 2a-2e.

A complete stack assembly will now be described with reference to Figures 3 to 6. This stack assembly consists of sixteen semiconductor devices interspersed between seventeen aluminium heatsinks 20a-20q. However, it will be readily appreciated that the heatsink 20i about which the stack assembly is symmetrically arranged consists of three individual heatsinks in direct contact with each other (i.e. not spaced apart by a semiconductor device). It will therefore be understood that the term "heatsink" as used herein should be taken to include two or more individual heatsinks that are not spaced apart by a semiconductor device. In general terms a stack assembly may consist of n semiconductor devices interspersed between n+1 heatsinks. The semiconductor devices that form the stack assembly can have the same topology or different topologies. For example, all sixteen of the semiconductor devices can be GTOs. Alternatively, the stack assembly may include different semiconductor devices configured in a convenient power circuit topology.

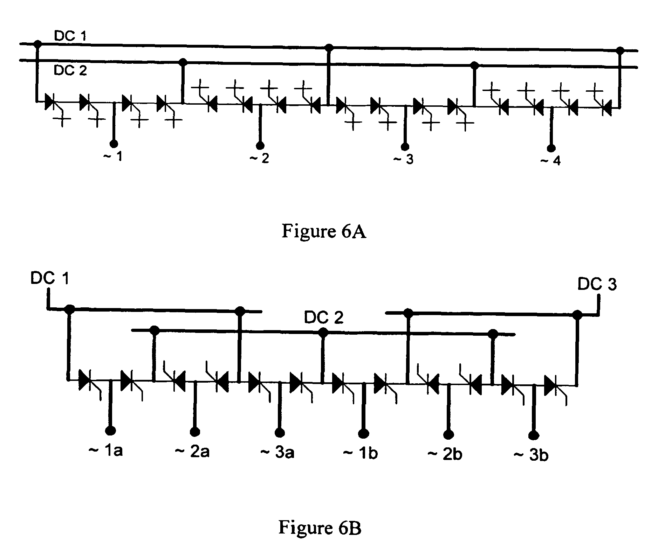

The particular arrangement of semiconductor devices shown in Figures 3 to 5 is a four phase bridge that employs two series connected 4.5 kV GTOs per arm. This is shown schematically in Figure 6A. The bridge has two dc terminals labelled DC1 and DC2 and four ac terminals labelled ∼1, ∼2, ∼3 and ∼4. The arms are disposed between respective dc terminals and ac terminals. For example, a first arm is disposed between the first dc terminal DC1 and the first ac terminal ∼1, and a second arm is disposed between the first ac terminal ∼1 and the second dc terminal DC2. Together, the first and second arms constitute a first phase of the bridge with four semiconductor devices. The second, third and fourth phases are formed in a corresponding manner.

A classical twelve pulse series thyristor rectifier is shown schematically in Figure 6B. Although not shown, such a stack assembly would employ twelve thyristor semiconductor devices interspersed between heatsinks. First three-phase ac terminals labelled ∼1a, ∼2a and ∼3a supply power to a first rectifier bridge whose dc terminals are labelled DC1 and DC2. Second three-phase ac terminals labelled ∼1b, ∼2b and ∼3b are phase shifted by 30 degrees with respect to the first ac terminals and supply power to a second rectifier bridge whose dc terminals are labelled DC2 and DC3. The dc terminal DC2 is therefore common to both rectifier bridges and thus the respective dc outputs of the first and second rectifier bridges are connected in series, their combined output being between the dc terminals DC3 (positive) and DC1 (negative). The mid point dc terminal DC2 can also be used in some applications.

The radial fins 26, 28 of each heatsink 20a-20q are aligned to define axial rows. Axial passageways are therefore formed between the radial fins 26, 28 along which a liquid dielectric coolant can flow when the stack assembly is positioned for use. The way in which the radial alignment of the heatsinks 20a-20q is maintained over the lifetime of the stack assembly is described in more detail below.

Figure 3 shows how a variety of different busbars, mechanical supports and auxiliary electrical components (e.g. snubber circuits) can be connected to the arms 32a, 32b of the radial fins 28. For example, a series of snubber capacitors 34 are connected to an arm of one of the radial fins 28 of heatsinks 20a-20h and 20j-20q by U-shaped busbars 36 which provide both electrical connection and mechanical support.

Four busbars 38 provide electrical connection to, and mechanical support for, the outgoing ac terminals of the stack assembly (not shown but represented schematically in Figure 6A by the ac terminals labelled ∼1, ∼2, ∼3 and ∼4). Other busbars 40 provide electrical connection, and mechanical support for, a pair of dc busbars 42 that run along the side of the stack assembly and connect to outgoing dc busbars (not shown but represented schematically in Figure 6A by the dc terminals labelled DC1 and DC2). The interconnections between heatsinks shown schematically in Figure 6A may be implemented by busbars that may optionally incorporate features to provide sufficient flexibility to avoid the generation of significant forces as a result of differential thermal expansion. Such features may include appropriately formed sections of busbar, but flexible braided or laminated foil links may be used in certain cases.

Threaded fasteners are used to secure the various busbars 36, 38 and 40 to the heatsinks and the arms 32a, 32b of the radial fins 28 are provided with suitable threaded openings for receiving the threaded fasteners.

The connections between external circuits and the dc busbars 42 and the outgoing ac terminals (not shown) of the stack assembly may employ quick release connectors (not shown).

Gate drive circuits 14 for the gate drive connections 12 are held in place between pairs of radial fins 26 by small clips 44.

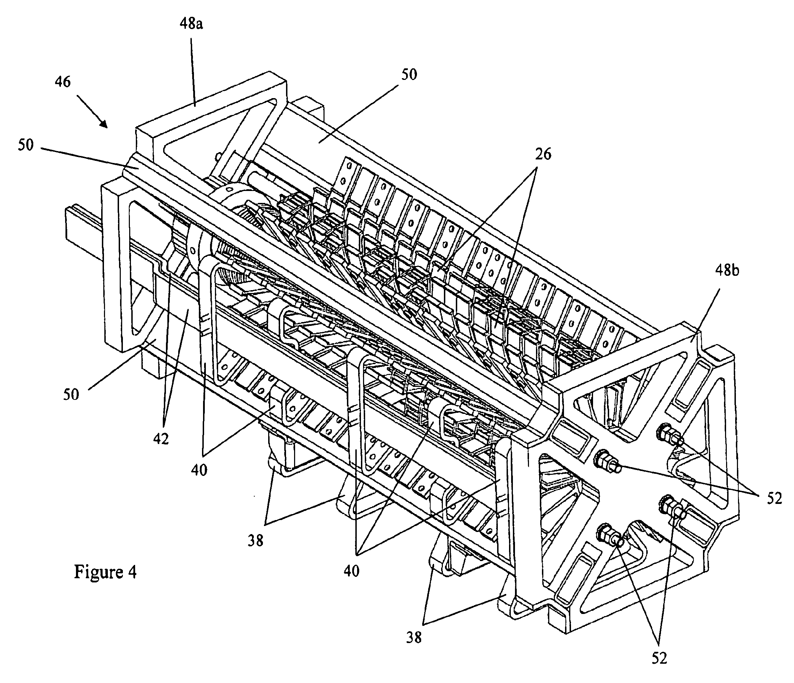

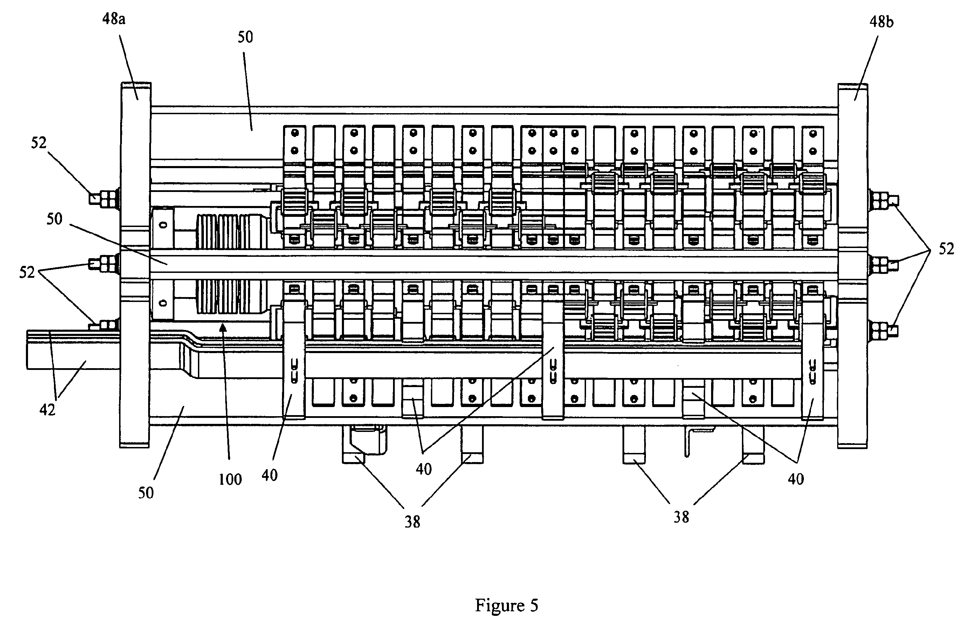

With reference to Figures 4 and 5, the stack assembly is surrounded by a rigid outer support frame 46. The frame includes a pair of end plates 48a and 48b with four longitudinal members 50 connected between them. The longitudinal members 50 are solid and are rigidly connected to a first end plate 48a. The longitudinal members 50 have a sliding interface with a second end plate 48b.

The longitudinal members 50 pass through the axial passageways between the arms 30a, 30b of the radial fins 28 and through corresponding axial openings in the second end plate 48b. Sliding interfaces between the longitudinal members 50 and the heatsinks 20a-20q and the second end plate 48b locate the stack assembly in the radial direction. More particularly, the radial fins 28 include flat surfaces 28a between the arms 32a, 32b that are in sliding contact with the longitudinal members 50. The second end plate 48b has corresponding flat surfaces that are in sliding contact with the longitudinal members 50. By having an arrangement comprising four longitudinal members 50 with successive angular displacements of 90 degrees relative to each other, radial forces in any direction may be transmitted from any heatsink 20a-20q and the second end plate 48b as a vector pair of forces into corresponding pairs of adjacent longitudinal members 50. In some cases, the sliding interfaces may be continued along the surfaces of the radial fins on either side of the flat surfaces 28a in order to provide additional bearing surface area.

The longitudinal members 50 are electrically insulated from the heatsinks 20a-20q by any convenient means. Suitable examples would include heat shrink sleeves or other coatings applied to the longitudinal members 50. Alternatively, insulation can be provided by an insulation material section that is formed to precisely fill the gap between the longitudinal members 50 and the heatsinks 20a-20q. The insulation material must be abrasion resistant and provide a sufficiently low coefficient of friction to allow the heatsinks 20a-20q to slide relative to the longitudinal members 50 and the insulation material in the axial direction without significantly interfering with the intended contact compression force throughout the length of the stack assembly. The sliding interfaces between the longitudinal members 50 and the second end plate 48b need not be electrically insulated as for the heatsinks 20a-20q, but they may be insulated for reasons of convenience or to improve the performance of the sliding interfaces, e.g. by reducing friction.

Four support rods 52 extend through the openings 30 provided in each of the radial fins 28. The support rods 52 carry predominantly tensile loads and make only a minor contribution to the radial alignment of the heatsinks 20a-20q and the overall stack assembly. The end plates 48a and 48b include four openings for receiving the support rods 52. The ends of the support rods 52 that pass through the openings in the end plates 48a and 48b have an external thread and the support rods are secured to the rigid outer support frame 46 using nuts or other convenient mechanical fixings.

The support rods 52 are electrically isolated from the heatsinks 20a-20q by any convenient means. Suitable examples would include heat shrink sleeves or other coatings applied to the support rods 52. Alternatively, insulation can be provided by an insulation material section that is formed to precisely fill the gap between the support rods 52 and the heatsinks 20a-20q. The insulation material must be abrasion resistant and provide a sufficiently low coefficient of friction to allow the heatsinks 20a-20q to slide relative to the support rods 52 and the insulation material in the axial direction without significantly interfering with the intended contact compression force throughout the length of the stack assembly.

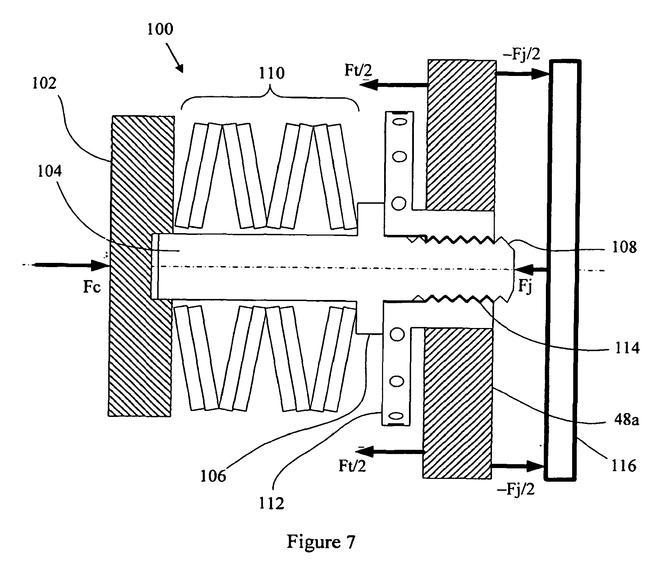

A common contact pressure system (clamping system) 100 applies a contact compression force along the axis of the stack assembly to ensure that proper electrical and thermal contact is maintained. The contact pressure system can set and regulate the contact compression force over the lifetime of the stack assembly. Detailed views of the contact pressure system 100 are shown in Figures 7 to 9.

Figure 7 shows the contact pressure system 100 during assembly where external tooling has been secured to allow the contact pressure force to be set. The contact pressure system 100 includes a loading pad 102 having a recess for accommodating a loading pin 104. The loading pin 104 incorporates a loading flange 106 and an externally threaded region 108. A compression spring 110 is represented by a series-parallel disc spring system (Belleville washers), but it will be readily appreciated that other suitable spring systems could be used.

A locking collar 112 is internally machined to be a precise fit on the loading pin 104 and the machined interface 114 is highlighted. The locking collar 112 incorporates any suitable rim feature to allow it to be rotated about the loading pin 104. In this case, the locking collar 112 includes a series of angularly spaced holes or openings that are designed to accommodate a G spanner or other suitable tool. The locking collar 112 has a region of circular cross section which has a sliding fit inside the end plate 48a and a flat pressure surface which bears against a corresponding surface on the end plate.

External tooling incorporates a force setting fixture 116 which applies a compression force Fj to the end of the loading pin 104 and tensile forces -Fj/2 to the extremities of the end plate 48a to preserve the balance of forces. For reasons of clarity, the end plate 48a in Figures 7 to 9 is shown as having only two extremities and two corresponding forces. However, it will be readily appreciated that in practice the end plate 48a may have any convenient number of extremities and in the preferred stack assembly shown in Figures 3 to 5 there are four extremities and four corresponding compression forces -Fj/4. The forces can be provided by a calibrated hydraulic jack or any other convenient device.

The loading pad 102 bears against an insulation pad (not shown) which in turn bears against the heatsink 20q to transmit the contact compression force to the stack assembly whilst electrically insulating the stack assembly from the contact pressure system 100 and support structures. A corresponding insulation pad 118 (Figure 3) is provided at the other end of the stack assembly between the heatsink 20a and the end plate 48b such that the stack assembly is effectively clamped between the contact pressure system 100 and the end plate 48b whilst electrically insulating the stack assembly from the contact pressure system 100 and support structures.

Figure 7 shows a desired contact compression force Fc applied to the loading pad where Fc = Fj. It can be seen that there is an axial gap or clearance between the corresponding surfaces of the locking collar 112 and the end plate 48a. The corresponding tensile forces Ft/2 are experienced in the support rods 52 in order to preserve the balance of forces. Again, for reasons of clarity, the end plate 48a in Figures 7 to 9 is shown as having only two extremities and two support rods. However, it will be readily appreciated that in practice the end plate 48a may have any convenient number of extremities and in the preferred stack assembly shown in Figures 3 to 5 there are four extremities and four support rods 52.

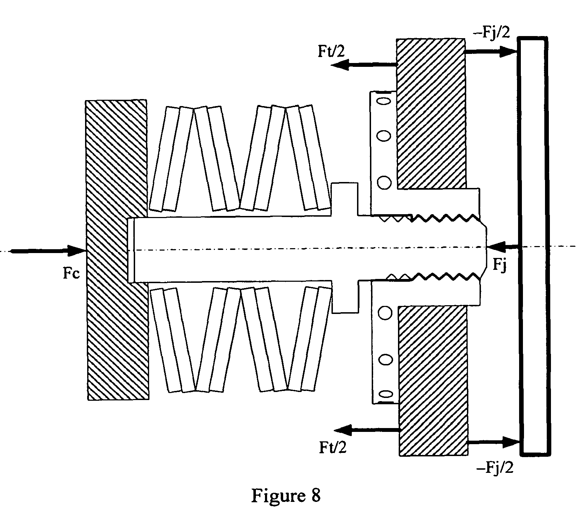

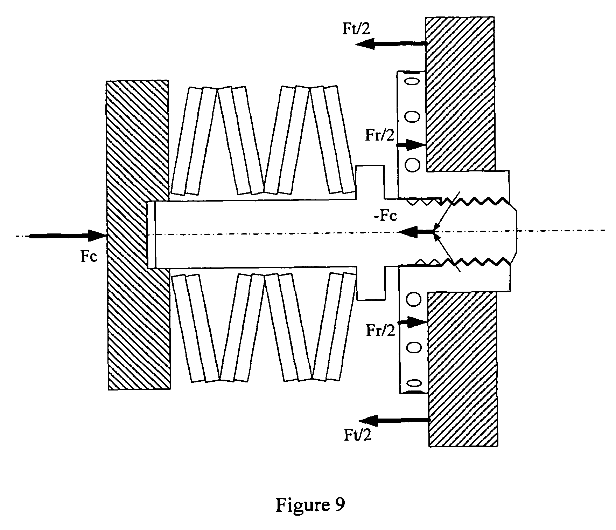

Figure 8 shows the contact pressure system 100 after the locking collar 112 has been rotated in order to close up the axial gap or clearance between the corresponding surfaces of the locking collar and the end plate 48a. At this stage, the thread engagement between the locking collar 112 and the loading pin 104, being nearly rigid, is such that the force setting fixture 116 can be removed (Figure 9) with little effect on the contact compression force Fc. However, in practice the thread engagement is slightly elastic and the clamping force Fc reduces slightly relative to the contact compression force Fj when the force setting fixture 116 is removed. The compression force Fj may be set to make allowance for this elasticity.

After removal of the force setting fixture 116 as shown in Figure 9, reaction forces Fr/2 equivalent to the tensile forces Ft/2 are experienced by the locking collar 112 and these are transferred by the highlighted thread engagement 114 into a compressive force -Fc within the loading pin 104.

A typical contact compression force may be about 32 kN ± 10% at room temperature and under all operating conditions. The contact compression force will preferably be uniformally distributed over the whole surface of the cathode and anode plates 6, 8 of each semiconductor device.

It will be readily appreciated that a number of effects may combine to influence the contact compression force that is experienced by the stack assembly. For example, the following may cause the contact compression force to increase: thermal expansion in the heatsinks, the cathode and anode plates of each semiconductor device, the semiconductor bodies, and other parts that are held in compression. The following may cause the contact compression force to decrease: thermal expansion or creep in any parts that are held in tension, creep in end plates, plastic flow in the heatsinks, plastic flow in any locally highly-loaded clamping hardware such as screw threads, seatings for the Belleville washers etc. The effect of friction in the above-described sliding interfaces on the contact compression force must be minimised and in practice this friction will have only a very small influence on the contact compression force (an influence having hysteresis that is governed by the cyclic behaviour of differential thermal expansion).

The entire stack assembly shown in Figures 3 to 5 may be located within a chamber or reservoir (not shown) of an electric machine or which is associated with an electrical machine or independent from it. The chamber is filled with a liquid dielectric coolant such as MIDEL. The liquid dielectric coolant is made to flow past the stack assembly in a direction that is parallel with the longitudinal axis of the stack assembly. For example, the chamber may form part of a coolant circuit through which the liquid dielectric coolant is pumped. Heat generated by the operation of the semiconductor devices is therefore transferred into the liquid dielectric coolant as it flows past and between the radial fins 26, 28 of the heatsinks 20a-20q.

The entire stack assembly may also be located within a fluid-tight housing (not shown). A plurality of housings may be secured around the stator assembly of an electrical machine. Coolant manifolds supply liquid dielectric coolant to the housings and remove liquid dielectric coolant from the housings. The housings are therefore filled with flowing liquid dielectric coolant and the stack assemblies are completely immersed in the liquid dielectric coolant. The liquid dielectric provides cooling and a dielectric environment in which the stack assemblies can be safely operated.

The longitudinal members 50 of the rigid outer structure are the main means of supporting the stack assembly within the chamber or fluid-tight housing. The longitudinal members 50 can be supported by any suitable external structure (not shown) which may incorporate sheet surfaces or box construction to direct the flow of liquid dielectric coolant. The longitudinal members 50 may be connected to, and supported by, a penetrator plate (not shown) through which the various signal level and power supply electrical interconnections pass so as to allow the gate drive electronics that are immersed in the liquid dielectric coolant to be connected to air cooled electronic circuits. The gate drive electronics that are immersed in the liquid dielectric coolant may be supported on any convenient structure which may, in turn, be secured to one or more of the longitudinal members 50 and/or the penetrator plate (not shown). Because all of the semiconductor devices have an "open" construction, the liquid dielectric coolant can penetrate into the stack assembly in the region of the power semiconductor devices. In particular, the liquid dielectric coolant will flow between the heatsinks, thereby enveloping the semiconductor devices and potentially entering any voids or cavities that may exist between the semiconductor bodies 4 and their respective contact plates 6, 8 and any associated gate drive circuit connections 12. The penetration of liquid dielectric coolant into the stack assembly is not impaired or hindered by the compliant outer ring 10 that surrounds the cathode and anode plates 6, 8 and the semiconductor body 4 of each semiconductor device. All regions of semiconductor devices must therefore be chemically compatible with the liquid dielectric. The liquid dielectric must not be applied to the stack assembly until the clamping force has been applied and the resultant clamping pressure resists penetration of liquid dielectric between the above-mentioned contacting asperities.

Since the whole stack assembly is flooded with liquid dielectric, it also follows that the associated snubber, gating and electrically interconnecting ancillaries can be designed to benefit from their dielectric and coolant environment.

Although the preferred embodiments of the present invention employ power semiconductor devices having an "open" construction, in examples not forming part of the present invention it is also possible to employ conventional fully housed press pack semiconductor devices within the same general arrangement.

## Claims

1. A stack assembly comprising:
at least one semiconductor device (2a-2d) interspersed between heatsinks (20a-20e) and adapted to be at least partially immersed in a liquid dielectric; the at least one semiconductor device (2a-2d) including a semiconductor body or wafer (4) and electrical contact plates (6, 8); and
pressure contact means (100) for applying a contact compression force substantially along the axis of the stack assembly to maintain proper thermal and electrical contact between the at least one semiconductor device (2a-2d) and adjacent heatsinks (20a-20e) and between the semiconductor body or wafer (4) and the electrical contact plates;
**characterised in that** the at least one semiconductor device (2a-2d) has an open construction and is not hermetically sealed in a housing such that when the at least one semiconductor device is at least partially immersed in the liquid dielectric it is flooded with the liquid dielectric to provide a dielectric environment.

2. A stack assembly according to claim 1, further comprising a plurality of semiconductor devices (2a-2d) with each semiconductor device being located between a pair of heatsinks (20a-20e).

3. A stack assembly according to claim 1 or claim 2, further comprising means (28, 28a, 50) for applying a radial alignment force to the stack assembly.

4. A stack assembly according to any preceding claim, wherein the heatsinks (20a-20d) have a plurality of radial cooling fins (26, 28).

5. A stack assembly according to claim 4, wherein one or more of the radial cooling fins (28) are adapted for the mounting of auxiliary electrical components.

6. An arrangement in which a stack assembly according to any preceding claim is located in a chamber containing a liquid dielectric such that the stack assembly is at least partially immersed in the liquid dielectric.

7. An arrangement according to claim 6, wherein the liquid dielectric is stationary.

8. An arrangement according to claim 6, wherein the liquid dielectric is made to flow past the stack assembly.

9. An arrangement according to claim 8, wherein the liquid dielectric is made to flow past the stack assembly in a direction that is substantially parallel to the axis of the stack assembly.

10. An arrangement according to any of claims 6 to 9, wherein the chamber is defined by a fluid-tight housing.

11. An arrangement according to any of claims 6 to 8, wherein a plurality of stack assemblies according to any of claims 1 to 5 are located in the chamber such that the stack assemblies are at least partially immersed in the liquid dielectric.

12. An arrangement according to claim 11, wherein at least one semiconductor device of one stack assembly is electrically connected to at least one semiconductor device of at least one different stack assembly.

## Patentansprüche

1. Stapelbaugruppe, die umfasst:
wenigstens eine Halbleitervorrichtung (2a-2d), die zwischen Wärmesenken (20a-20e) eingefügt ist und dafür ausgelegt ist, wenigstens teilweise in ein flüssiges Dielektrikum eingetaucht zu werden; wobei die wenigstens eine Halbleitervorrichtung (2a-2d) einen Halbleiterkörper oder -wafer (4) und elektrische Kontaktplatten (6, 8) aufweist; und
Druckkontaktmittel (100), um eine Kontaktkompressionskraft im Wesentlichen längs der Achse der Stapelbaugruppe auszuüben, um einen geeigneten thermischen und elektrischen Kontakt zwischen der wenigstens einen Halbleitervorrichtung (2a, 2d) und benachbarten Wärmesenken (20a-20e) und zwischen dem Halbleiterkörper oder -wafer (4) und den elektrischen Kontaktplatten aufrecht zu erhalten;
**dadurch gekennzeichnet, dass** die wenigstens eine Halbleitervorrichtung (20a-20d) eine offene Konstruktion besitzt und nicht in einem Gehäuse hermetisch abgedichtet ist, so dass die wenigstens eine Halbleitervorrichtung dann, wenn sie wenigstens teilweise in das flüssige Dielektrikum getaucht ist, mit dem flüssigen Dielektrikum geflutet wird, um eine dielektrische Umgebung zu schaffen.

2. Stapelbaugruppe nach Anspruch 1, die ferner mehrere Halbleitervorrichtungen (2a-2d) umfasst, wobei sich jede Halbleitervorrichtung zwischen einem Paar Wärmesenken (20a-20e) befindet.

3. Stapelbaugruppe nach Anspruch 1 oder Anspruch 2, ferner mit Mitteln (28, 28a, 50) zum Ausüben einer radialen Ausrichtkraft auf die Stapelbaugruppe.

4. Stapelbaugruppe nach einem vorhergehenden Anspruch, wobei die Wärmesenken (20a-20d) mehrere radiale Kühlrippen (26, 28) besitzen.

5. Stapelbaugruppe nach Anspruch 4, wobei eine oder mehrere der radialen Kühlrippen (28) für die Montage zusätzlicher elektrischer Komponenten ausgelegt sind.

6. Anordnung, in der sich eine Stapelbaugruppe nach einem vorhergehenden Anspruch in einer Kammer befindet, die ein flüssiges Dielektrikum enthält, so dass die Stapelbaugruppe wenigstens teilweise in das flüssige Dielektrikum getaucht ist.

7. Anordnung nach Anspruch 6, wobei das flüssige Dielektrikum stationär ist.

8. Anordnung nach Anspruch 6, wobei das flüssige Dielektrikum dazu veranlasst wird, an der Stapelbaugruppe vorbeizufließen.

9. Anordnung nach Anspruch 8, wobei das flüssige Dielektrikum dazu veranlasst wird, an der Stapelbaugruppe in einer Richtung vorbeizufließen, die zu der Achse der Stapelbaugruppe im Wesentlichen parallel ist.

10. Anordnung nach einem der Ansprüche 6 bis 9, wobei die Kammer durch ein fluiddichtes Gehäuse definiert ist.

11. Anordnung nach einem der Ansprüche 6 bis 8, wobei sich in der Kammer mehrere Stapelbaugruppen nach einem der Ansprüche 1 bis 5 befinden, so dass die Stapelbaugruppen wenigstens teilweise in das flüssige Dielektrikum getaucht sind.

12. Anordnung nach Anspruch 11, wobei wenigstens eine Halbleitervorrichtung wenigstens einer Stapelbaugruppe mit wenigstens einer Halbleitervorrichtung wenigstens einer anderen Stapelbaugruppe elektrisch verbunden ist.

## Revendications

1. Ensemble à éléments superposés comprenant :
au moins un dispositif à semi-conducteur (2a-2d) disposé entre des dissipateurs thermiques (20a-20e) et adapté pour être immergé au moins en partie dans un diélectrique liquide ; le au moins un dispositif à semi-conducteur (2a-2d) comprenant une tranche ou un corps de semi-conducteur (4) et des plaques de contacts électriques (6, 8) ; et
un moyen de contact à pression (100) destiné à appliquer une force de compression de contact sensiblement le long de l'axe de l'ensemble à éléments superposés afin de maintenir un contact thermique et électrique approprié entre le au moins un dispositif à semi-conducteur (2a-2d) et des dissipateurs thermiques adjacents (20a-20e) et entre la tranche ou le corps de semi-conducteur (4) et les plaques de contacts électriques (6, 8) ;
**caractérisé en ce que** le au moins un dispositif à semi-conducteur (2a-2d) présente une construction ouverte et n'est pas scellé hermétiquement dans un boîtier de telle sorte que lorsque le au moins un dispositif à semi-conducteur est immergé au moins en partie dans le diélectrique liquide, il est noyé dans le diélectrique liquide afin de fournir un environnement diélectrique.

2. Ensemble à éléments superposés selon la revendication 1, comprenant en outre une pluralité de dispositifs à semi-conducteur (2a-2d), chaque dispositif à semi-conducteur se situant entre une paire de dissipateurs thermiques (20a-20e).

3. Ensemble à éléments superposés selon la revendication 1 ou 2, comprenant en outre des moyens (28, 28a, 50) destinés à appliquer une force d'alignement radiale à l'ensemble à éléments superposés.

4. Ensemble à éléments superposés selon l'une des revendications précédentes, dans lequel les dissipateurs thermiques (20a-20d) présentent une pluralité d'ailettes de refroidissement radiales (26, 28).

5. Ensemble à éléments superposés selon la revendication 4, dans lequel une ou plusieurs des ailettes de refroidissement radiales (28) sont adaptées au montage de composants électriques auxiliaires.

6. Agencement dans lequel un ensemble à éléments superposés selon l'une quelconque des revendications précédentes est placé dans une chambre qui contient un diélectrique liquide, de telle sorte que l'ensemble à éléments superposés soit immergé au moins en partie dans le diélectrique liquide.

7. Agencement selon la revendication 6, dans lequel le diélectrique liquide est fixe.

8. Agencement selon la revendication 6, dans lequel le diélectrique liquide est conçu pour circuler devant l'ensemble à éléments superposés.

9. Agencement selon la revendication 8, dans lequel le diélectrique liquide est conçu pour circuler devant l'ensemble à éléments superposés, dans une direction sensiblement parallèle à l'axe de l'ensemble à éléments superposés.

10. Agencement selon l'une quelconque des revendications 6 à 9, dans lequel la chambre est définie par un logement étanche.

11. Agencement selon l'une quelconque des revendications 6 à 8, dans lequel une pluralité d'ensembles à éléments superposés selon l'une quelconque des revendications 1 à 5 se situent dans la chambre, de telle sorte que les ensembles à éléments superposés soient immergés au moins en partie dans le diélectrique liquide.

12. Agencement selon la revendication 11, dans lequel au moins un dispositif à semi-conducteur d'un ensemble à éléments superposés est connecté électriquement à au moins un dispositif à semi-conducteur d'un ensemble à éléments superposés différent au moins.
